# EUROPEAN PATENT SPECIFICATION

(11) **EP 2 450 946 B1**
(45) Date of publication and mention of the grant of the patent: **18.01.2017**
(21) Application number: 10793905.0
(22) Date of filing: 21.04.2010
(51) Int. Cl.: H01L 21/306, H01L 21/316

(54) **METHOD FOR REMOVING FERROELECTRIC CSD COATING FILM**
VERFAHREN ZUR ENTFERNUNG EINES FERROELEKTRISCHEN CSD-BESCHICHTUNGSFILMS
PROCÉDÉ PERMETTANT DE RETIRER UN FILM FERROÉLECTRIQUE DEPOSÉ PAR CSD

(30) Priority: 30.06.2009 JP 2009156064; 13.07.2009 JP 2009165140; 27.01.2010 JP 2010016071
(43) Date of publication of application: 09.05.2012
(73) Proprietor: Mitsubishi Materials Corporation, Chiyoda-ku Tokyo 100-8117 (JP)
(72) Inventor: SOYAMA, Nobuyuki, Sanda-shi Hyogo 669-1339 (JP); WATANABE, Toshiaki, Sanda-shi Hyogo 669-1339 (JP); SAKURAI, Hideaki, Naka-shi Ibaraki 311-0102 (JP)
(74) Representative: Hoffmann Eitle
(86) International application number: PCT/JP2010/057059
(87) International publication number: WO 2011/001734

(56) References cited:
- JP-A- 4 171 820
- JP-A- 8 017 817
- JP-A- 2002 320 901
- US-A- 5 849 467
- US-A- 6 066 581

## Description

### BACKGROUND OF THE INVENTION

### Field of the Invention

The present invention relates to a method for producing a ferroelectric thin film, in CSD method such as sol-gel method or the like for forming ferroelectric thin film such as PZT film, SBT film or the like by coating and baking material solution.

Priority is claimed on Japanese Patent Application No. 2009-156064, filed June 30, 2009, Japanese Patent Application No. 2009-165140, filed July 13, 2009, and Japanese Patent Application No. 2010-16071, filed January 27, 2010, the content of which is incorporated herein by reference.

### Description of Related Art

Ferroelectric such as PZT (Pb zirconate titanate), SBT (strontium bismuth tantalate) or the like have perovskite-type crystal structure, and is prospective for applying devices such as a capacitor, a ferroelectric memory (FeRAM: Ferroelectric Random Access Memory) and the like. As a film-formation method for thin film of ferroelectric, Chemical Solution Deposition, so-called CSD method, such as sol-gel method, MOD method (Metal Organic Decomposition), or a method using these method together is known (refer to Patent Documents 1 and 2).

Sol-gel method is a method for forming an oxide film (ferroelectric thin film) by: applying sol (i.e., material solution) of metal alkoxide on a substrate so as to form a coated film; hydrolyzing and polycondensing the coated film into a gelled film which is lost liquidity; and heating and baking the gelled film into the oxide film. As methods for forming a coated film of material solution on the substrate (i.e., a wafer), a dip-coating method in which the substrate is dipped in the material solution, a roll-coating method, and a spin-coating method in which the material solution is supplied to the spinning substrate so as to form film, or the like. Especially, in the spin-coating method, film thickness is apt to engross at an outer peripheral edge of the substrate and the material solution is apt to be supplied to a back surface of the substrate.

In sol-gel method (hereinafter, denoted as CSD method; and solution thereof is denoted as material solution), if the film thickness is too large, heat-treated film is apt to crack and the film is removed and becomes particles, so that yield of devices may be decreased. Therefore, the coated film at the outer peripheral edge of the substrate is removed before heat-treating.

In a case in which lead perovskite-type oxide such as PZT is formed, Pt (platinum) and the like is used for an under layer of PZT film. However, a substrate having a structure in which the edge thereof is not coated and SiO₂ which is material of the substrate is exposed is also general. When PZT film and SiO₂ are in contact with each other, since PZT film is apt to crack although the film thickness is small, the coated film is removed at the outer peripheral edge of the substrate before heat-treating also in this case.

As a method for removing a coated film of the substrate at the outer peripheral edge, there is a method so-called edge-bead rinse (EBR) in which organic solvent is in contact with the outer peripheral edge of the substrate with spinning the substrate after applying material solution.

In Patent Documents 3 and 4, methods for removing a photoresist layer formed on a surface of a substrate by EBR, in which thinner composition is used for rinse of the removal.

Patent Document 1: Japanese Patent Application, First Publication No. 2001-72926
Patent Document 2: Japanese Patent Application, First Publication No. 2002-29752
Patent Document 3: Japanese Patent Application, First Publication No. 2005-227770
Patent Document 4: Japanese Patent Application, First Publication No. 2007-324393

The document US-A-6 066 581 discloses a process for forming a perovskite ferro-electric film by a sol-gel process.

The document US-A-5 849 467 discloses a method for removing edge beads of photoresist on wafers.

### SUMMARY OF THE INVENTION

### Problems to be Solved by the Invention

When operating EBR by spraying or dropping organic solvent to coated film in CSD method, it is extremely difficult to control a cross-sectional shape of film in the vicinity of a spraying area. That is, a part in which the film is thick may crack after heat-treating, and the crack may cause localized removal of film, so that particles may be occurred.

### Means for Solving the Problem

The present invention is contrived in view of the circumstances and an object of the present invention is to prevent generation of particles in CSD method by removing film at an outer peripheral edge of a substrate without cracks or localized removal.

In the method for producing a ferroelectric film according to the present invention the liquid for removing CSD coated film before heat-treating in CSD method includes water and organic solvent, in which the organic solvent is selected one or more from among β-diketones, β-ketoesters, polyhydric alcohol, carboxylic acids, α-hydroxy carboxylic acid, α-hydroxy carbonyl derivatives, and hydrazone derivatives, and in which the organic solvent and the water is mixed in a weight ratio of 50:50 to 5:95.

When removing a part of a coated film of material solution in CSD method, generally, it is presumable that solvent in the material solution is preferably used. In the material solution, methanol, ethanol, butanol and the like are used as the solvent. However, if spraying or dropping solvent such as methanol, ethanol, butanol and the like on the outer peripheral edge of the substrate for removing the coated film at the outer peripheral edge of the substrate after coated by the material solution, cracks or localized removal may be occurred after heat-treating in the vicinity of the spraying area or dropping area.

The cause is considered as below. That is, when the solvent such as methanol, ethanol, butanol and the like is sprayed or dropped on the gelled film of the material solution, the solvent permeates into the gelled film. The film melted by the permeation of the solvent is removed in part outward radial direction by centrifugal force. The permeation of the solvent inward radial direction and the elongation of the melted film outward radial direction act on each other, so that film thickness is uneven in the vicinity of the spraying area or the dropping area by dispersion of force which acts on each other, and the like. This is considered as the reason that cracks or localized removals may be occurred in the vicinity of the spraying area or the dropping area after the heat-treating.

On the other hand, if the gelled film is removed by liquid for removing used in the method according to the present invention, since water is hard to permeate into the film, the film thickness is even in an outer position than the spraying area or the dropping area along the radial direction, so that the cracks or the localized removals can be prevented. Furthermore, by adding organic solvent which can stabilize metal alkoxide of the material solution by hydrolyzability thereof, the removed material solution is prevented from being hydrolyzed and precipitate is avoided, so that pollution by the precipitate of working environment can be prevented.

In the liquid for removing CSD coated film used in the method according to the present invention, it is preferable that the organic solvent and the water be mixed in a weight ratio of 50:50 to 5:95, more preferably, 30:70 to 10:90.

Since the liquid for removing which is in contact with the coated film of the material solution includes water as a main component with adding appropriate volume of organic solvent so that the precipitate by the hydrolyze of the material solution can be prevented from being generated, film characteristic of the coated film is not changed.

In the liquid for removing CSD coated film used in the method of the present invention, it is preferable that: the β-diketone be acetylacetone, the β-ketoester be methyl 3-oxobutanoate and/or ethyl 3-oxobutanoate, the polyalcohol be one or more selected from the group consisting of propylene glycol, diethylene glycol, and triethylene glycol, the carboxylic acids be one or more selected from the group consisting of acetic acid, propionic acid, and butyric acid, the α-hydroxy carboxylic acid be one or more selected from the group consisting of lactic acid, mandelic acid, and citric acid, tartaric acid, and oxalic acid, the α-hydroxy carbonyl derivative be acetol and/or acetoin, and the hydrazone derivative be 2-propanone hydrazone.

It is preferable that the liquid for removing CSD coated film used in the method according to the present invention remove the coated film formed by coating material solution including a mixed solvent A and a mixed solvent B as solvents, the mixed solvent A be one or more selected from the group consisting of propylene glycol, diethylene glycol, and triethylene glycol, and the mixed solvent B be one or more selected from the group consisting of methanol, ethanol, 1-propanol, 2-propanol, and 1-butanol.

The method for producing ferroelectric thin film in CSD method according to the present invention includes the steps of: forming a coated film by applying material solution comprising organic metallic compound for forming ferroelectric thin film on a substrate; removing the coated film at an outer peripheral edge of the substrate by rotating the substrate and spraying or dropping the liquid for removing CSD coated film at the outer peripheral edge of the rotating substrate; and forming ferroelectric thin film by heat-treating the coated film.

In the method for producing ferroelectric thin film according to the present invention, the material solution may form perovskite-type oxide thin film including Pb.

In the method for producing ferroelectric thin film according to the present invention, the material solution may form laminar perovskite-type oxide thin film including Bi.

### Effects of the Invention

According to the present invention, since the coated film is removed by liquid including water for removing, the cracks or localized removals are not occurred at the removed part, so that an even surface can be obtained. Furthermore, by using the liquid including organic solvent for removing, hydrolyzing of the removed material solution is restrained and the precipitate is avoided, so that pollution of working environment by the precipitate can be prevented.

### BRIEF DESCRIPTION OF THE DRAWINGS

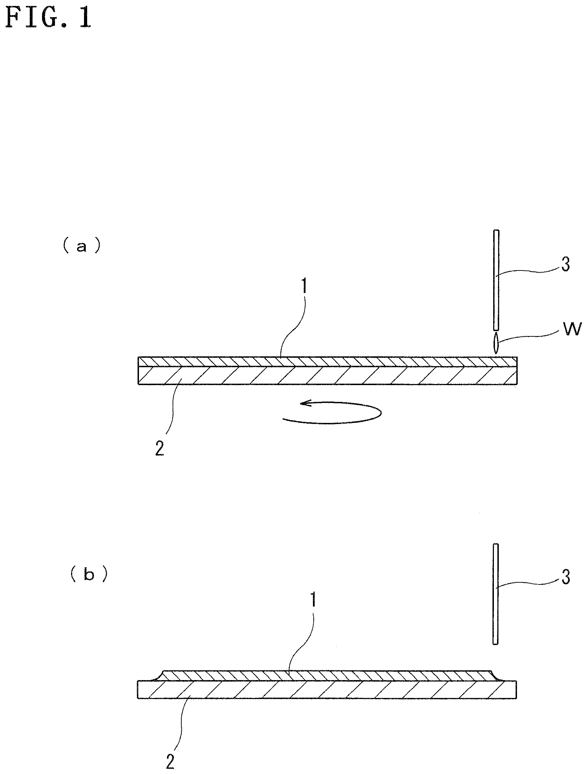

In FIG. 1, the part (a) is a sectional view showing a state in which a substrate is rotated and liquid for removing is dropped on an outer peripheral edge of the substrate of an embodiment used in the method according to the present invention; and the part (b) is a sectional view showing the substrate in which an outer peripheral edge of a coated film is removed in the embodiment according to the present invention.

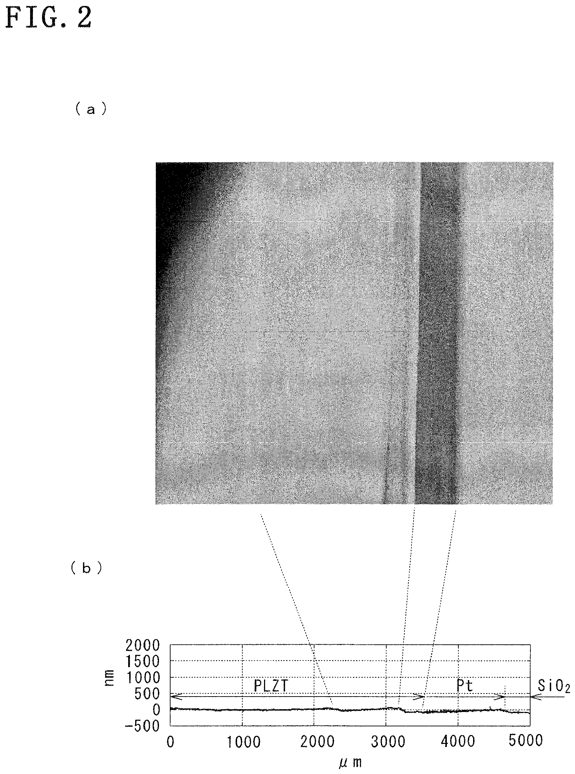

In FIG. 2, the part (a) is a surface photomicrograph showing a vicinity of an outer peripheral edge of ferroelectric thin film which is formed by an experiment of a method according to the present invention; and the part (b) is a surface-profile view showing the outer peripheral edge of the ferroelectric thin film of the experiment measured by a surface-profile measuring instrument.

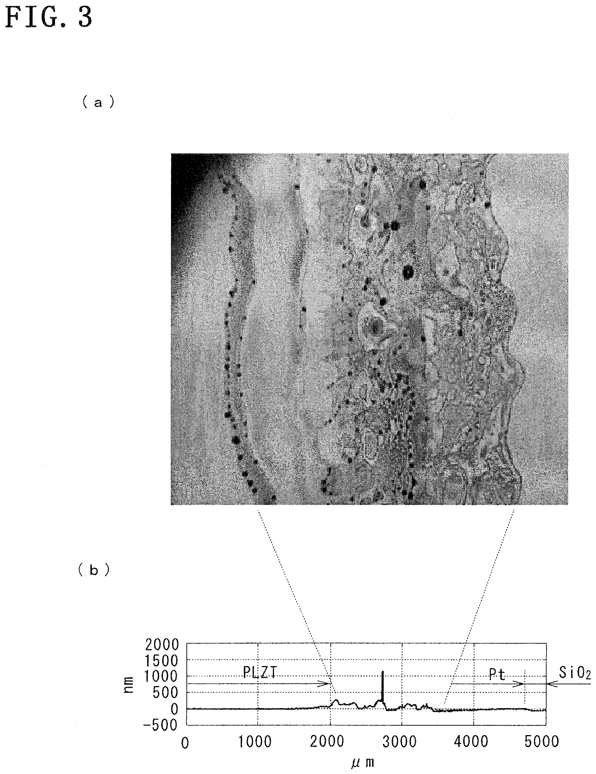

In FIG. 3, the part (a) is a surface photomicrograph showing a vicinity of an outer peripheral edge of a ferroelectric thin film which is formed by a comparative experiment; and the part (b) is a surface-profile view showing the outer peripheral edge of the ferroelectric thin film of the comparative experiment measured by the surface-profile measuring instrument.

### DESCRIPTION OF THE PREFERRED EMBODIMENTS

Hereinafter, a liquid for removing CSD coated film used in the method of the present invention and a method for producing ferroelectric thin film according to the present invention will be described with reference to the drawings.

The method for producing ferroelectric thin film is appropriate for producing perovskite-type oxide thin film including Pb such as PZT, PLZT and the like, and laminar perovskite-type oxide thin film including Bi such as SBT, SBTN and the like. The method for producing ferroelectric thin film includes the steps of: forming a gelled film (a coated film) 1 by applying material solution including organic metallic compound on a substrate 2 (material solution applying process); removing the gelled film 1 at an outer peripheral edge of the substrate 2 by spraying or dropping liquid for removing including organic solvent (liquid for removing film) at the outer peripheral edge of the rotating substrate 2 (EBR process); and forming ferroelectric thin film by heat-treating the gelled film 1 (heating treatment process).

(Material Solution for CSD Method) Material solution in CSD method is made by dissolving metallic-compound material into a solvent and adding stabilizing agents and the like. For example, followings are the material solutions for PLZT and SBTN.

For the metallic-compound material of the material solution for PLZT: organic salt such as acetate (i.e., lead acetate, lanthanum acetate) and the like and alkoxide such as diisopropoxylead and the like as lead compounds and lanthanum compounds; and alkoxide such as tetraethoxytitanium, tetraisopropoxytitanium, tetra-n-butoxy titanium, tetra-i-butoxy titanium, tetra-t-butoxy titanium, dimethoxydiisopropoxytitanium as titanium compounds are appropriate. However, organic salts or organometallic complexes can be used. Zirconium compounds are similar to the titanium compounds. Also, composite metallic-compounds including two or more metallic materials can be used. Conjugated metallic-compound including two or more metal components can be used. Furthermore, very small quantity of doped element can be included.

For the metallic-compound material of the material solution for SBTN (i.e., CSD solution), alkoxide such as Sr isopropoxide, Sr butoxide and the like and carboxylate such as 2-ethylhexanoic acid Sr and the like can be used as Sr organic metallic compound. Sr organic metallic compound may be Sr diethylene glycolate or Sr triethylene glycolate. In this case, therefore, Sr diethylene glycolate or Sr triethylene glycolate can be generated by adding metal Sr to diethylene glycol or triethylene glycol as solvent so as to react the metal Sr on heating. As Bi organic metallic compound, 2-ethyl hexanoic acid Bi can be used. As Ta organic metallic compound, Ta diethylene glycolate or Ta triethylene glycolate can be used. As Nb organic metallic compound, Nb diethylene glycolate or Nb triethylene glycolate can be used.

As organic solvent (solvent A), single solvent or mixed solvent selected from the group including propylene glycol, diethylene glycol, and triethylene glycol can be used.

The organic solvent and the organic metallic compounds are mixed in an appropriate ratio with respect to desired metallic composition concentration. Also, in order to homogenize solution, the solvent is heated and refluxed.

In order to regulate the concentration and wetting characteristic of the solution obtained as above so as to fit for application, the concentration of the solution is controlled by using the other solvent (solvent B). As the organic solvent B, single solvent or mixed solvent selected from the group including methanol, ethanol, 1-propanol, 2-propanol, and 1-butanol can be used. Generally, alcohols (e.g., ethanol, isopropyl alcohol, butanol), ketones (e.g., acetone, methyl ethyl ketone), ethers (e.g., diethyl ether, tetrahydrofuran), and carboxylic acid (e.g., acetic acid, 2-ethylhexanoic acid), hydrocarbon (n-hexane, n-octane) and the like can be used. However, mildly-toxic ethanol, isopropyl alcohol, butanol are preferable.

Sum concentration of organic metallic compounds in the solution is preferably about 0.1 to 20% by weight at reduced quantity of metal-oxide.

Stabilizing agent such as β-diketones (e.g., acetylacetone, heptafluorobutanoylpivaloylmethane, dipivaloylmethane, trifluoroacetylacetone, benzoylacetone and the like), ketone acids (e.g., diacetic acid, propionylacetic acid, benzoylacetic acid and the like) and the like may be blended into the material solution at 0.2 to 3 times moll rate to metal as necessary.

(Material Solution Applying Process) Gelled film 1 is formed on whole surface of a substrate 2 by applying the material solution to the substrate 2.

As material of substrate, a silicon wafer (single crystal), a plate of silicon, glass, alumina, quarts or the like having coated film of metals such as platinum, nickel and the like, or perovskite-type conductive-oxide such as ruthenium oxide, iridium oxide, strontium ruthenate (SrRuO₃), lanthanum strontium cobalt oxide ((LaₓSr₁₋ₓCoO₃) or the like can be used.

In a case in which the material solution is applied on the substrate 2, a spin-coating method is general. Furthermore, the other applying method such as spraying, soaking and the like can be used.

(EBR Process) As shown in FIG. 1 (a), liquid for removing film W is sprayed or dropped from a nozzle 3 above an outer peripheral edge of the substrate 2 with rotating the substrate 2 in which the gelled film 1 is formed after applying the material solution; thereby removing the gelled film 1 at the outer peripheral edge as shown in FIG. 1(b).

Liquid for removing W has a mixed ratio 50:50 to 5:95 of the organic solvent and water;

The organic solvent is prevented from permeating from the outer peripheral edge of the film into the film since the water ratio of the organic solvent is larger than 50:50, so that the gelled film is not swollen by the permeation of the organic solvent, and the cracks after heat-treating can be avoided.

It is more preferable that the organic solvent and the water be mixed in a ratio of 50:50 to 5:95 in the liquid for removing W. When residual liquid after applying the material solution on the substrate and EBR composition W are in contact with each other, if the ratio of the water is smaller than 5:95, metal alkoxide in the material solution is prevented from being hydrolyzed and precipitate formation is prevented, so that the mixed liquid is stabilized. Therefore, particle pollution by scattering of powder and the like can be prevented beforehand, and high-quality film can be obtained.

Furthermore, the organic solvent and water are mixed more preferably at a rate of 30:70 to 10:90 in the liquid for removing W. By setting the mixed ratio as above, beforementioned two phenomena (i.e., the cracks result from the permeation of the organic solvent and the particle pollution result from the precipitate formation) can be stably improved. That is to say, it is preferable that the film characteristic of the coated film be not changed by using the compound including water as the main component by adding the organic solvent not too much but proper enough to prevent formation of the precipitate by the hydrolyze of the material solution.

In the liquid for removing W, the organic solvent functions as stabilizing agent for preventing formation of the precipitates by decomposing hydrolytic compounds such as metal alkoxide and the like in the material solution. As the organic solvent, compounds having one or more atoms which can be a donor pair of an electron pair such as oxygen, nitrogen, sulfur and the like in an element, which can stabilize the metal compounds by coordinate bonding with metal, i.e., the organic solvent which can be used as stabilizing agent of metal alkoxide may be used. Specifically, as the organic solvent, single solvent or mixed solvent selected from the group including β-diketones, β-ketoesters, polyhydric alcohol, carboxylic acids, α-hydroxy carboxylic acid, α-hydroxy carbonyl derivatives, and hydrazone derivatives can be used. In this case, acetylacetone is used as β-diketone. As β-ketoester, methyl 3-oxobutanoate and/or ethyl 3-oxobutanoate are/is used. As polyalcohol, one or more selected from propylene glycol, diethylene glycol, triethylene glycol is/are used. As carboxylic acids, one or more selected from acetic acid, propionic acid, and butyric acid is used. As α-hydroxy carboxylic acid, one or more selected from lactic acid, mandelic acid, and citric acid, tartaric acid, and oxalic acid is used. As α-hydroxy carbonyl derivatives, acetol and acetoin are used. As hydrazone derivative, 2-propanone hydrazone is used.

Rotation speed of the substrate 2 in EBR process is, for example, set in a range of 1000 to 3000 rpm. A position of spraying or dropping the liquid for removing W can be set appropriately in accordance with a position of a removing object. For example, when removing 5 mm in width from the outer peripheral edge of the substrate 2, the liquid for removing W is sprayed or dropped at a position radially 5 mm inner from the outer peripheral edge, so that the film is removed at 5mm in width outer than the position of spraying or dropping. Quantity of spraying or dropping may be set appropriately in accordance with a thickness and the like of the gelled film 1 that is enough to wash away the gelled film 1 from the removing target area. It is enough to spray or drop the liquid for removing W for 2 to 5 seconds with the above-mentioned rotation speed.

In this EBR process, the nozzle 3 may be moved radially outward while rotating the substrate 2 so that the gelled film 1 at the outer peripheral edge is easy to flow if needed.

(Heating Treatment Process) Heating treatment process further includes a drying process, a temporary baking process, and a crystallization annealing process.

(Drying Process) The gelled film 1 after being removed the outer peripheral edge thereof is dried and the solvent is removed. Drying temperature is normally 80 to 200°C along with the type of the solvent; preferably, 100 to 180°C. However, since the solvent is removed while heated in the next process for convert the metal composition in the material solution to metal-oxide, the drying process of the film is not always necessary.

(Temporary Baking Process) After that, as a temporary baking process, the substrate 2 after drying the gelled film 1 is heated so that the organic metallic compound is completely hydrolyzed or thermally decomposed and converted into metal-oxide, and then oxide film of metal-oxide is formed. This heating process is performed generally in an atmosphere including water vapor in the sol-gel method having need of hydrolysis, for example, in air or water-vapor atmosphere (e.g., nitrogen atmosphere including water vapor); or performed in an atmosphere including oxygen in the MOD method in which the organic metal compound is thermally decomposed. Heating temperature is normally 150 to 550°C along with the type of metal-oxide, preferably, 300 to 450°C. Heating time is selected so as to completely advance the hydrolysis and the thermal decomposition, normally, 1 minute to 1 hour.

In the sol-gel method or the like, it is hard to obtain sufficient film thickness which is necessary for perovskite-type oxide thin film by one application. Therefore, the material solution is overglazed by repeating the material solution applying process from the temporary baking process. The gelled film 1 is removed at the outer peripheral edge in each application, and desired thickness of the metal-oxide film is obtained.

(Crystallization Annealing Process) The oxide film obtained as above is amorphous material or crystalline material having insufficient crystallinity, so that the polarizability is low and the oxide film cannot be used as ferroelectric thin film. Therefore, for the last crystallization annealing process, the oxide film is baked at temperature higher than crystallization temperature of the metal-oxide, so that crystalline metal-oxide thin film having perovskite type crystalline structure is obtained. The baking processes for crystallization may be operated for each applied films subsequently to the temporary baking processes. However, it is economically advantageous that the baking process in high temperature is operated finally at once.

The baking temperature for crystallization can be normally set comparatively low within 500 to 800°C, e.g., 550 to 700°C. Therefore, the substrate having heat resistance to the baking temperature is used. The baking (annealing) time for crystallization is normally 1 minute to 1 hour. The baking atmosphere is normally set as air or oxygen; but it is not limited.

The perovskite-type oxide thin film formed as above is formed evenly on the substrate without cracks or localized removals at even the outer peripheral edge. Therefore, ferroelectric thin film without particles can be obtained.

As described above, as lead perovskite-type oxide such as PZT or the like, in a case in which SiO₂ of the substrate is bare at the outer peripheral edge with respect to Pt layer of the surface of the substrate, PZ which is applied on SiO₂ is apt to crack. The method for removing coated film in the above producing method is effective for removing the film in the area in which SiO₂ is apt to crack. In this case, water is sprayed or dropped slightly inside the inner peripheral edge of the area of SiO₂.

### -Experiments-

A thin film of PLZT as perovskite-type oxide including Pb and a thin film of SBTN as laminar-perovskite type oxide including Bi were formed, and the surfaces after removing the films at the outer peripheral edges of the substrates were observed. Experiments and comparative experiments of the observations will be explained.

Composition of material solution for perovskite-type oxide thin film including Pb (PLZT) was below.

Lead acetate trihydrate as lead material, lanthanum acetate hydrate as lanthanum material, zirconium n-butoxide as zirconium material, and titanium tetraisopropoxide as titanium material were mixed with solvent A and acetylacetone as stabilizing agent having double number of moles of a total of Zr and Ti, and rotary flown at 150°C for 1 hour in nitrogen atmosphere. Then, distillation under reduced pressure at 150°C was performed so that low-boiling organic substances such as by-products were eliminated; dilution by solvent B was performed so that equivalent oxide concentration was 10 wt%; so that various CSD solutions for perovskite-type oxide thin film including Pb were obtained. PLZT compositions, the solvent A, and the solvent B are indicated in Table 1.

**[Table 1]**

| Material Solution No. | Ratio of Metal Atoms Pb/La/Zr/Ti | Solvent A | Solvent B |
|---|---|---|---|
| 1-1 | 110/0/52/48 | propylene glycol | 1-butanol |
| 1-2 | 110/0/52/48 | triethylene glycol | 2-propanol |
| 1-3 | 110/3/52/48 | propylene glycol | 1-propanol |
| 1-4 | 110/3/52/48 | triethylene glycol | 1-butanol |
| 1-5 | 100/10/0/100 | propylene glycol | methanol |
| 1-6 | 100/10/0/100 | diethylene glycol | ethanol |

Composition of material solution for laminar perovskite-type oxide including Bi (SBTN) was below.

Bismuth 2-ethylhexoate as bismuth material, strontium 2-ethylhexoate as strontium material, tantalum pentaethoxide as tantalum material, niobium pentaethoxide as niobium material were mixed with solvent A and 2-ethyl hexanoic acid as stabilizing agent having 2.5 times of moles of a total of Ta and Nb, and rotary flown at 150°C for 1 hour in nitrogen atmosphere. Then, distillation under reduced pressure at 150°C was performed so that low-boiling organic substances such as by-products were eliminated; dilution by solvent B was performed so that equivalent oxide concentration was 10 wt%; so that various CSD solutions for laminar perovskite-type oxide thin film including Bi were obtained. SBTN compositions, the solvent A, and the solvent B are indicated in Table 2.

**[Table 2]**

| Material Solution No. | Ratio of Metal Atoms Sr/Bi/Ta/Nb | Solvent A | Solvent B |
|---|---|---|---|
| 2-1 | 1/2.2/2/0 | diethylene glycol | ethanol |
| 2-2 | 1/2.2/2/0 | triethylene glycol | 2-propanol |
| 2-3 | 1/2.2/1/1 | propylene glycol | 1-propanol |
| 2-4 | 1/2.2/1/1 | diethylene glycol | ethanol |
| 2-5 | 1/2.2/0/2 | propylene glycol | 1-butanol |
| 2-6 | 1/2.2/0/2 | diethylene glycol | ethanol |

If the film thickness is large, the cracks are apt to appear at the edge. In order to compare generation statuses of edge cracks in such a condition with the case in which 10 wt% solution is used, 25 wt% solution was manufactured as the same method as that of the above-mentioned material solution for perovskite-type oxide thin film including Pb and the material solution for laminar perovskite-type oxide thin film including Bi. Composition of PLZT, the solvent A and the solvent B are indicated in Table 3. Also, composition of SBTN, the solvent A and the solvent B are indicated in Table 4.

**[Table 3]**

| Material Solution No. | Ratio of Metal Atoms Pb/La/Zr/Ti | Solvent A | Solvent B |
|---|---|---|---|
| 3-1 | 110/0/52/48 | propylene glycol | ethanol |
| 3-2 | 110/0/52/48 | triethylene glycol | 2-propanol |
| 3-3 | 110/3/52/48 | propylene glycol | 1-propanol |
| 3-4 | 110/3/52/48 | triethylene glycol | 1-butanol |
| 3-5 | 100/10/0/100 | propylene glycol | 1-butanol |
| 3-6 | 100/10/0/100 | diethylene glycol | ethanol |

**[Table 4]**

| Material Solution No. | Ratio of Metal Atoms Sr/Bi/Ta/Nb | Solvent A | Solvent B |
|---|---|---|---|
| 4-1 | 1/2.2/2/0 | diethylene glycol | ethanol |
| 4-2 | 1/2.2/2/0 | triethylene glycol | 2-propanol |
| 4-3 | 1/2.2/1/1 | propylene glycol | 1-propanol |
| 4-4 | 1/2.2/1/1 | diethylene glycol | ethanol |
| 4-5 | 1/2.2/0/2 | propylene glycol | 1-butanol |
| 4-6 | 1/2.2/0/2 | diethylene glycol | ethanol |

By those material solutions, the perovskite-type oxide thin film including Pb (PLZT thin film) and the laminar perovskite-type oxide (SBTN) thin film including Bi were formed. The substrate was a Pt (200 nm)/SiO₂ (500 nm)/Si substrate manufactured by forming SiO₂ film by thermal oxidation on a surface of a Si substrate of 4 inch diameter so as to have thickness of 500 nm, and then forming Pt film by sputtering on the SiO₂ film except an area from the outer peripheral edge to 3 mm radially inner side.

(Perovskite-type oxide thin film including Pb) First, as a pilot study, the material solutions 1-1 to 1-6 in Table 1 were sprayed on the 4 inch-Pt/SiO₂/Si substrates at 2 ml, the substrates were rotated under a condition of 500 rpm × 3 seconds, and then the substrates were rotated at 3000 rpm × 15 seconds so as to coat overall the substrate. After that, the substrates were heated for 5 minutes on a heated hot plate at 350°C so as to pyrolyze the organic substances, and then oxide films including lead were obtained. After repeating the operation for 6 times so that the material solutions were applied without the EBR process, the substrates were baked at 700°C for 5 minutes by a device for Rapid Thermal Annealing (RTA), and the perovskite-type oxide thin films including Pb were obtained.

The substrates used in the experiment were not coated by Pt at the most outer peripheral edge, so that the cracks were generated after baking at the position in which the PLZT thin film and SiO₂ were directly in contact with each other.

(Experiment 1) As an experiment 1, on the same Pt/SiO₂/Si substrates, as the above pilot experiment, after 10 wt% material solutions 1-1 to 1-6 were spin-coated, while rotating the substrates were rotated at 2500 rpm by spin-coater in order to avoid reaction of the film including Pb and SiO₂ when baking, the liquids for removing 1 to 62 were sprayed at a position radially inside 5mm from the outer peripheral edge of the substrates, so that the EBR process for dissolve the gelled film was operated. The liquid for removing 1 to 62, as shown in Table 5 and Table 6, include the organic solvent and water at subscribed weight ratio. The liquids for removing 1 to 50 include one organic solvent X and water; and the liquids for removing 51 to 60 include water and the organic solvent in which two organic solvents X and Y are mixed at a subscribed weight ratio. The liquid for removing 62 is water and do not include organic solvent.

By heating the above substrates on the hot plate as the pilot experiment, oxide films including lead were obtained in a state in which the outer peripheral edges thereof were removed by etching. By repeating this operation with performing the EBR process in each case so that the material solutions were applied 6 times and then baking by RTA at 700°C for 5 minutes, the perovskite-type oxide thin films including Pb were obtained.

No cracks or localized removals were generated at the edge portions of the films including Pb in the obtained samples of the experiments using any of the liquids for removing 1 to 62. Although the coated film of the CSD solution is scattered around the substrate with the liquid for removing in the EBR process, when using the liquid for removing 1 to 61 including the organic solvent, the film of the CSD solution was not thicken with gelling and not attached to the circumference.

Also, the 25 wt% material solutions 3-1 to 3-6 indicated in Table 3 were used, the EBR processes were operated using the liquids for removing 1 to 62 as the above, and the hot plate process and the RTA processes were performed, so that the perovskite-type oxide thin films including Pb were obtained. No cracks or localized removals were generated at the edge portions of the films including Pb in the obtained sample of the experiments using any of the liquids for removing 1 to 62, so that it was supported that the cracks and the like can be avoided even though the film thickness is large in the EBR process.

**[Table 5]**

| Liquid for Removing | Constituent of Organic Solvent | | | Organic Solvent: Water |
|---|---|---|---|---|
| No. | Solvent X | Solvent Y | X:Y (Weight Ratio) | (Weight Ratio) |
| 1 | acetylacetone | - | - | 5:95 |
| 2 | acetylacetone | - | - | 10:90 |
| 3 | acetylacetone | - | - | 15:85 |
| 4 | methyl oxobunanoate | - | - | 5:95 |
| 5 | ethyl oxobunanoate | - | - | 5:95 |
| 6 | propylene glycol | - | - | 5:95 |
| 7 | propylene glycol | - | - | 10:90 |
| 8 | propylene glycol | - | - | 20:80 |
| 9 | propylene glycol | - | - | 30:70 |
| 10 | propylene glycol | - | - | 50:50 |
| 11 | diethylene glycol | - | - | 5:95 |
| 12 | diethylene glycol | - | - | 10:90 |
| 13 | diethylene glycol | - | - | 20:80 |
| 14 | diethylene glycol | - | - | 30:70 |
| 15 | diethylene glycol | - | - | 50:50 |
| 16 | triethylene glycol | - | - | 5:95 |
| 17 | triethylene glycol | - | - | 10:90 |
| 18 | triethylene glycol | - | - | 20:80 |
| 19 | triethylene glycol | - | - | 30:70 |
| 20 | triethylene glycol | - | - | 50:50 |
| 21 | acetic acid | - | - | 5:95 |
| 22 | acetic acid | - | - | 10:90 |
| 23 | acetic acid | - | - | 20:80 |
| 24 | acetic acid | - | - | 30:70 |
| 25 | acetic acid | - | - | 50:50 |
| 26 | propionic acid | - | - | 5:95 |
| 27 | propionic acid | - | - | 10:90 |
| 28 | propionic acid | - | - | 20:80 |
| 29 | propionic acid | - | - | 30:70 |
| 30 | propionic acid | - | - | 50:50 |

**[Table 6]**

| Liquid for Removing | Constituent of Organic Solvent | | | Organic Solvent: Water |
|---|---|---|---|---|
| No. | Solvent X | Solvent Y | X:Y (Weight Ratio) | (Weight Ratio) |
| 31 | butyric acid | - | - | 5:95 |
| 32 | butyric acid | - | - | 10:90 |
| 33 | butyric acid | - | - | 15:85 |
| 34 | butyric acid | - | - | 5:95 |
| 35 | butyric acid | - | - | 5:95 |
| 36 * | monoethanolamine | - | - | 5:95 |
| 37* | monoethanolamine | - | - | 10:90 |
| 38* | monoethanolamine | - | - | 20:80 |
| 39* | monoethanolamine | - | - | 30:70 |
| 40 * | monoethanolamine | - | - | 50:50 |
| 41 * | diethanolamine | - | - | 5:95 |
| 42 * | diethanolamine | - | - | 10:90 |
| 43 * | diethanolamine | - | - | 20:80 |
| 44 * | diethanolamine | - | - | 30:70 |
| 45 * | diethanolamine | - | - | 50:50 |
| 46 * | triethanolamine | - | - | 5:95 |
| 47 * | triethanolamine | - | - | 10:90 |
| 48 * | triethanolamine | - | - | 20:80 |
| 49 * | triethanolamine | - | - | 30:70 |
| 50 * | triethanolamine | - | - | 50:50 |
| 51 | acetylacetone | propylene glycol | 1:1 | 5:95 |
| 52 | propylene glycol | diethylene glycol | 1:1 | 10:90 |
| 53 | propylene glycol | triethylene glycol | 1:1 | 20:80 |
| 54 | propylene glycol | acetic acid | 1:1 | 30:70 |
| 55* | propylene glycol | monoethanolamine | 1:1 | 50:50 |
| 56 | diethylene glycol | triethylene glycol | 1:1 | 5:95 |
| 57 | diethylene glycol | propionic acid | 1:1 | 10:90 |
| 58* | diethylene glycol | diethanolamine | 1:1 | 20:80 |
| 59 | triethylene glycol | butyric acid | 1:1 | 30:70 |
| 60* | triethylene glycol | triethanolamine | 1:1 | 50:50 |
| 61* | monoethanolamine | triethanolamine | 1:1 | 50:51 |
| 62 | - | - | - | 0:100 |

| | | | | |
|---|---|---|---|---|
| * Reference Example | | | | |

### Example 62 does not belong to the invention.

(Comparative Experiment 1) Next, as a comparative experiment 1, under the same conditions as the experiment 1 except that n-butanol was used as liquid for removing instead of the liquids for removing 1 to 62 in Tables 5 and 6, samples of perovskite-type oxide thin film including Pb were obtained. The cracks and localized removals were generated at the edge portion of the film including Pb of the obtained samples.

### (Laminar Perovskite-type Oxide Thin Film Including Bi)

(Experiment 2) As an experiment 2, also for laminar perovskite-type oxide thin film including Bi, in a similar manner as the perovskite-type oxide thin film including Pb (the experiment 1), 10 wt% material solutions 2-1 to 2-6 in Table 2 were spin-coated on the 4 inch-Pt/SiO₂/Si substrates, then the EBR process was operated; that is, the liquids for removing 1 to 62 indicated in Tables 5 and 6 were sprayed to 5mm radially-inside from the outer peripheral edges of the substrates with rotating the substrates at 2500 rpm by the spin-coater in order to avoid cracking by thickness at the outer peripheral edge of the substrate, so that the gelled films were dissolved. Then, the substrates were heated on the hot plate as that of the perovskite-type oxide thin film including Pb, oxide thin films including Bi in a state in which the outer peripheral edges thereof were etched were obtained. The operation was repeated as that for the perovskite-type oxide thin film including Pb so as to apply the material solution for six times with performing the EBR processes in each case, and then the substrates were baked at 800°C for 5 minutes by the RTA, so that samples of laminar perovskite-type oxide thin film including Bi were obtained.

No cracks or localized removals were generated at the outer peripheral edge portions of the films including Bi in the obtained samples using any of the liquids for removing 1 to 62. Also, when the liquids for removing 1 to 61 including the organic solvent, the scattered coated films of the material solution around the substrate were not thicken with gelling and not attached to the circumference.

Also, the 25 wt% material solutions 4-1 to 4-6 indicated in Table 4 were used, the EBR processes were operated using the liquids for removing 1 to 62, and the hot plate process and the RTA processes were performed, so that samples of laminar perovskite-type oxide thin film including Bi were obtained. No cracks or localized removals were generated at the edge portions of the films including Bi in the obtained samples using any of the liquids for removing 1 to 62, so that it was supported that the cracks and the like can be avoided even though the film thickness is large in the EBR process.

(Comparative Experiment 2) As a comparative experiment 2, under the same conditions as the experiment 2 except that n-butanol was used as solvent for EBR instead of the liquids for removing in Tables 5 and 6, samples of laminar perovskite-type oxide thin film including Pb was obtained. The cracks and localized removals were generated at the edge portion of the film including Pb of the obtained sample.

Next, a step on the surface was measured with respect to those samples (in the experiments 1, 2 and the comparative experiments 1, 2) obtained as above by a stylus surface-profile measuring instrument "Dektak" made of Veeco Instruments Inc., U.S.A. In the comparative experiments 1 and 2, steps of a few hundred nm were ascertained at an outer peripheral portion of ferroelectric thin film in an area of 1000 to 1500 µm in width. However, in the samples of the experiments 1 and 2, small steps having size of 100 µm or less were ascertained, but the surfaces of the samples were very flat and smooth.

In FIG.2, a part (a) is a surface micrograph of the thin film of the experiment 1, and a part (b) is a result of the measurement by the surface-profile measuring instrument. In FIG. 3, a part (a) is a surface micrograph of the shin film of the comparative experiment 1, and a part (b) is a result of the measurement by the surface-profile measuring instrument. It is obvious from comparison of the figures, the unevenness of the cracks and the like is observable in the comparative experiment 1 at a boundary phase of the film (i.e., an area between two dotted lines in FIG. 3); on the other, the surface is very flat and smooth in the experiment 1.

When the material solutions 1-1 to 1-6 of Table 1 and the material solutions 2-1 to 2-6 in Table 2 were added to proper quantity of water in a beaker, precipitates were ascertained to be generated. However, when the material solution was added to the liquid for removing 1 to 61 of Tables 5 and 6, precipitates which clouded the liquid were not ascertained. Especially among Tables 5 and 6, with respect to the liquids for removing in which a mixed ratio of the organic solvent and water is 30:70 to 10:90, the material solution were melted and the liquid became clear.

The present invention is not limited to the above-described embodiments and various modifications may be made without departing from the scope of the present invention.

Although the PLZT film and the SBTN film were mainly described in the above embodiments, it can be applied when forming the other ferroelectric thin film formed by CSD method.

### [Industrial Applicability]

Since CSD coated film is removed by liquid for removing including water, cracks, localized removals and the like are not generated to the removed part, so that the surface of the ferroelectric thin film can be smoothed. Furthermore, since the liquid for removing includes the organic solvent, the removed material solution can be prevented from hydrolyzing and the precipitates can be avoided, so that pollution of working environment by the precipitates can be prevented.

## Claims

1. A method for producing a ferroelectric thin film in a Chemical Solution Deposition (CSD) method comprising the steps of:
forming a coated film by applying a material solution comprising an organic metallic compound for forming a ferroelectric thin film on a substrate;
removing the coated film at an outer peripheral edge of the substrate by spraying or dropping a liquid on an outer peripheral edge of the substrate while rotating the substrate; and then
forming a ferroelectric thin film by heat-treating the coated film,
wherein the liquid comprises water and organic solvent,
the organic solvent is one or more selected from the group consisting of β-diketones, β-ketoesters, polyhydric alcohol, carboxylic acids, α-hydroxy carboxylic acid, α-hydroxy carbonyl derivatives, and hydrazone derivatives, and
the weight ratio of the organic solvent to the water is 50:50 to 5:95.

2. The method according to Claim 1, wherein the weight ratio of the organic solvent to the water is 30:70 to 10:90.

3. The method according to Claim 1, wherein:
the β-diketone is acetylacetone,
the β-ketoester is methyl 3-oxobutanoate and/or ethyl 3-oxobutanoate,
the polyalcohol is one or more selected from the group consisting of propylene glycol, diethylene glycol, and triethylene glycol,
the carboxylic acids is one or more selected from the group consisting of acetic acid, propionic acid, and butyric acid,
the α-hydroxy carboxylic acid is one or more selected from the group consisting of lactic acid, mandelic acid, citric acid, tartaric acid, and oxalic acid,
the α-hydroxy carbonyl derivative is acetol and/or acetoin, and
the hydrazone derivative is 2-propanone hydrazone.

4. The method according to Claim 1, wherein the material solution includes a solvent A and solvent B as solvents,
the solvent A is one or more selected from the group consisting of propylene glycol, diethylene glycol, and triethylene glycol, and
the solvent B is one or more selected from the group consisting of methanol, ethanol, 1-propanol, 2-propanol, and 1-butanol.

5. The method according to Claim 1, wherein the material solution forms a perovskite-type oxide thin film including Pb.

6. The method according to Claim 1, wherein the material solution forms a laminar perovskite-type oxide thin film including Bi.

## Patentansprüche

1. Verfahren zur Herstellung eines ferroelektrischen Dünnfilms in einem chemischen Lösungsabscheidungs (CSD)-Verfahren, das die folgenden Schritte umfasst:
Bildung eines Beschichtungsfilms durch Auftragen einer Materiallösung umfassend eine organische metallische Verbindung zur Bildung eines ferroelektrischen Dünnfilms auf einem Substrat,
Entfernen des Beschichtungsfilms an einer Außenrandkante des Substrats, indem eine Flüssigkeit auf eine Außenrandkante des Substrats unter Rotation des Substrats gesprüht oder getropft wird, und anschließend
Bilden eines ferroelektrischen Dünnfilms durch Wärmebehandeln des Beschichtungsfilms,
wobei die Flüssigkeit Wasser und organisches Lösungsmittel enthält,
das organische Lösungsmittel eines oder mehrere, ausgewählt aus der Gruppe bestehend aus β-Diketonen, β-Ketoestern, mehrwertigen Alkoholen, Carbonsäuren, α-Hydroxycarbonsäure, α-Hydroxycarbonylderivaten und Hydrazonderivaten, ist und
das Gewichtsverhältnis des organischen Lösungsmittels zu dem Wasser 50:50 bis 5:95 beträgt.

2. Verfahren gemäß Anspruch 1, worin das Gewichtsverhältnis des organischen Lösungsmittels zu dem Wasser 30:70 bis 10:90 beträgt.

3. Verfahren gemäß Anspruch 1, worin:
das β-Diketon Acetylaceton ist,
der β-Ketoester Methyl-3-oxobutanoat und/oder Ethyl-3-oxobutanoat ist,
der Polyalkohol einer oder mehrere, ausgewählt aus der Gruppe bestehend Propylenglykol, Diethylenglykol und Triethylenglykol, ist,
die Carbonsäuren eine oder mehrere, ausgewählt aus der Gruppe bestehend aus Essigsäure, Propionsäure und Buttersäure, ist,
die α-Hydroxycarbonsäure eine oder mehrere, ausgewählt aus der Gruppe bestehend aus Milchsäure, Mandelsäure, Zitronensäure, Weinsäure und Oxalsäure, ist,
das α-Hydroxycarbonylderivat Acetol und/oder Acetoin ist und
das Hydrazonderivat 2-Propanonhydrazon ist.

4. Verfahren gemäß Anspruch 1, worin die Materiallösung ein Lösungsmittel A und ein Lösungsmittel B als Lösungsmittel einschließt,
das Lösungsmittel A eines oder mehrere, ausgewählt aus der Gruppe bestehend aus Propylenglykol, Diethylenglykol und Triethylenglykol, ist und
das Lösungsmittel B eines oder mehrere, ausgewählt aus der Gruppe bestehend aus Methanol, Ethanol, 1-Propanol, 2-Propanol und 1-Butanol, ist.

5. Verfahren gemäß Anspruch 1, worin die Materiallösung einen Oxiddünnfilm vom Perovskit-Typ einschließlich Pb bildet.

6. Verfahren gemäß Anspruch 1, worin die Materiallösung einen laminaren Oxiddünnfilm vom Perovskit-Typ einschließlich Bi bildet.

## Revendications

1. Procédé de production d'un film mince ferroélectrique dans un procédé de dépôt chimique en solution (CSD), comprenant les étapes consistant à :
former un film déposé en appliquant une solution de matière comprenant un composé métallique organique pour la formation d'un film mince ferroélectrique sur un substrat ;
retirer le film déposé au niveau d'une arête périphérique extérieure du substrat en pulvérisant ou en versant goutte à goutte un liquide sur une arête périphérique extérieure du substrat tout en faisant tourner le substrat; et puis
former un film mince ferroélectrique par traitement thermique du film déposé,
dans lequel le liquide comprend de l'eau et un solvant organique,
le solvant organique est un ou plusieurs solvants choisis dans le groupe constitué par les β-dicétone, les β-cétoesters, l'alcool polyhydrique, les acides carboxyliques, l'acide α-hydroxy carboxylique, les dérivés d'α-hydroxycarbonyle, et les dérivés d'hydrazone, et
le rapport en poids entre le solvant organique et l'eau est de 50 : 50 à 5 : 95.

2. Procédé selon la revendication 1, dans lequel le rapport en poids entre le solvant organique est l'eau est de 30 : 70 à 10 : 90.

3. Procédé selon la revendication 1, dans lequel :
la β-dicétone est l'acétylacétone,
le β-cétoester est le 3-oxobutanoate de méthyle et/ou le 3-oxobutanoate d'éthyle,
le polyalcool est un ou plusieurs choisis dans le groupe constitué par le propylène glycol, le diéthylène glycol et le triéthylène glycol,
les acides carboxyliques sont un ou plusieurs choisis dans le groupe constitué par l'acide acétique, l'acide propionique, et l'acide butyrique,
l'acide α-hydroxy carboxylique est un ou plusieurs choisis dans le groupe constitué par l'acide lactique, l'acide mandélique, l'acide citrique, l'acide tartrique et l'acide oxalique,
le dérivé d'α-hydroxycarbonyle est l'acétol et/ou l'acétoïne, et
le dérivé d'hydrazone est la 2-propanone hydrazone.

4. Procédé selon la revendication 1, dans lequel la solution de matière comprend un solvant A et un solvant B comme solvants,
le solvant A est un ou plusieurs choisis dans le groupe constitué par le propylène glycol, le diéthylène glycol et le triéthylène glycol, et
le solvant B est un ou plusieurs choisis dans le groupe constitué par le méthanol, l'éthanol, le 1-propanol, le 2-propanol, et le 1-butanol.

5. Procédé selon la revendication 1, dans lequel la solution de matière forme un film mince d'oxyde de type pérovskite comprenant du Pb.

6. Procédé selon la revendication 1, dans lequel la solution de matière forme un film mince d'oxyde de type pérovskite laminaire comprenant du Bi.
